# EUROPEAN PATENT APPLICATION

(11) **EP 2 149 803 A1**
(43) Date of publication of application: **03.02.2010**
(21) Application number: 08776993.1
(22) Date of filing: 29.05.2008
(51) Int. Cl.: G02B 5/20, G03F 7/038, G03F 7/075, G03F 7/40, H01L 51/50, H05B 33/10, H05B 33/12, H05B 33/22

(54) **METHOD FOR PRODUCING SUBSTRATE WITH PARTITION WALL AND PIXEL FORMED THEREON**

(30) Priority: 30.05.2007 JP 2007143638
(71) Applicant: Asahi Glass Company, Limited, Chiyoda-ku Tokyo 100-8405 (JP)
(72) Inventor: ISHIZEKI, Kenji, Tokyo 100-8405 (JP); TAKAHASHI, Hideyuki, Tokyo 100-8405 (JP)
(74) Representative: Perrey, Ralf
(86) International application number: PCT/JP2008/059931
(87) International publication number: WO 2008/149776

(57) **Abstract**

To provide a process for producing a substrate having partition walls and pixels formed thereon, by which it is possible to obtain partition walls excellent in the liquid repellency and pixels having an ink layer excellent in the uniformity in the thickness.

A process for producing a substrate having partition walls and pixels formed thereon, which comprises forming partition walls on a substrate by a step (11) of coating the substrate with a photosensitive composition comprising a polymer (A) having a side chain containing a fluorine atom-containing group or a silicon atom-containing group and a side chain containing an ethylenic double bond in one molecule, a step (12) of drying a coating film of the photosensitive composition, an exposure step (13), a development step (14) and a post-exposure step (15); and forming a film by a step (21) of injecting an ink within dots which are regions partitioned by the partition walls and a step (22) of drying a coating film of the ink, the film satisfying (h1-h2)/h1<0.3 where h1 is the maximum thickness of an ink layer in one dot and h2 is the minimum thickness, thereby to obtain pixels.

## Description

### TECHNICAL FIELD

The present invention relates to a process for producing a substrate having partition walls and pixels formed thereon to be prepared, for example, by an ink jet printing technique.

### BACKGROUND ART

In recent years, a low cost process utilizing an ink jet printing technique has been proposed as a process for producing an optical element such as a color filter or an inorganic EL display device.

For example, in production of a color filter, partition walls are formed by photolithography, and then dots which are regions partitioned by the partition walls are sprayed and coated with inks of R (red), G (green) and B (blue) by an ink jet method to form pixels having a colored layer.

In production of an organic EL display device, partition walls are formed by photolithography, and then dots which are regions partitioned by the partition walls are sprayed and coated with solution inks of a hole transport material and a luminescent material by an ink jet method to form pixels having a hole transport layer, a luminescent layer, etc.

In the ink jet method, it is necessary to prevent color mixing of inks between adjacent pixels. Accordingly, the partition walls are required to have a repellency against water, an organic solvent or the like constituting the ink jet coating solution, i.e. a so-called liquid repellency.

Further, in the ink jet method, it is necessary to form pixels excellent in the uniformity in the ink layer thickness. Accordingly, the dots which are regions partitioned by the partition walls are required to have wettability by an ink, i.e. a so-called liquid affinity.

Patent Document 1 discloses formation of partition walls by coating a substrate with a photosensitive composition, and carrying out drying, exposure, development and heat treatment.
Patent Document 1: JP-A-2005-60515
Patent Document 2: W02004/79454

### DISCLOSURE OF THE INVENTION

### OBJECT TO BE ACCOMPLISHED BY THE INVENTION

However, when an ink was injected by an ink jet method into dots which are regions partitioned by partition walls formed by the above conventional method, to form an ink layer, the thickness of an ink layer sometimes became non-uniform. If a color filter or an organic EL display device was prepared by using such an ink layer, a so-called edge leakage took place wherein the thickness of the ink layer in the vicinity of partition walls became thin, and the periphery of the partition walls looked white. Such non-uniformity in the thickness of the ink layer was particularly distinct when partition walls were formed with a low exposure dose, while it is desired to lower the exposure dose in the exposure step in order to increase the resolution of the partition walls.

Therefore, it is an object of the present invention to provide a process for producing a substrate having partition walls and pixels formed thereon, by which it is possible to obtain partition walls excellent in the liquid repellency and pixels having an ink layer excellent in the uniformity in the thickness even when the exposure dose is low in the exposure step.

### MEANS TO ACCOMPLISH THE OBJECT

The present invention provides a process for producing a substrate having partition walls and pixels formed thereon, which comprises forming partition walls on a substrate by a step (11) of coating the substrate with the following photosensitive composition, a step (12) of drying a coating film of the photosensitive composition, an exposure step (13), a development step (14) and a post-exposure step (15); and forming a film by a step (21) of injecting an ink within dots which are regions partitioned by the above partition walls and a step (22) of drying a coating film of the ink, the film satisfying (h1-h2)/h1 <0.3 where h1 is the maximum thickness of an ink layer in one dot and h2 is the minimum thickness, thereby to obtain pixels:
photosensitive composition: a photosensitive composition comprising a polymer (A) having a side chain containing a group represented by the following formula 1 or a group represented by the following formula 2 and a side chain containing an ethylenic double bond in one molecule:

   -CFXR^{f} (1)

   wherein X is a hydrogen atom, a fluorine atom or a trifluoromethyl group, and R^{f} is an alkyl group having at most 20 carbon atoms which may have an etheric oxygen atom, at least one of hydrogen atoms of which is substituted by a fluorine atom, or a fluorine atom;

   -(SiR¹R²O)ₙ-SiR¹R²R³ (2)

   wherein each of R¹ and R² which are independent of each other, is a hydrogen atom, an alkyl group, a cycloalkyl group or an aryl group, R³ is a hydrogen atom or a C₁₋₁₀ organic group, and n is an integer of from 1 to 200.

The polymer (A) contained in the photosensitive composition of the present invention has a side chain containing a group represented by the formula 1 or a group represented by the formula 2, and it thus has a surface migration characteristics and will migrate to the vicinity of the coating film surface in the drying step (12). Thus, the liquid repellency against an ink will be developed at the upper surface of partition walls to be obtained by curing the photosensitive composition.

Further, the polymer (A) has a side chain containing an ethylenic double bond, and thus, it can be cured and fixed at the coating film surface in the exposure step (13). However, in a case where the exposure dose in the exposure step (13) is low, there may be a case where some molecules of the polymer (A) may not undergo a curing reaction and may remain in the partition walls without being removed from the system in the development step. In the conventional method, such non-reacted remaining molecules are considered to have migrated from the upper surface of the partition walls to the side surfaces of the partition walls or to dots to contaminate the dots in the postbaking step (16) which is carried out after the development step (14).

In the present invention, the process has a post-exposure step (15) after the development step (14), whereby the curing reaction of the polymer (A) is carried out sufficiently thereby to prevent migration of unreacted remaining molecules to dots. That is, the upper surfaces of the partition walls are excellent in the liquid repellency against an ink, and the side surfaces of the partition walls or dots are excellent in affinity to an ink. Accordingly, the side surfaces of the partition walls or the dots will have high ink wettability, and the ink will uniformly spread within the dots, and the ink will not be repelled on the side surfaces of the partition walls. Therefore, it is possible to obtain an ink layer having a high uniformity in the thickness, which satisfies (h1-h2)/h1<0.3, where h1 is the maximum thickness of an ink layer to be formed, and h2 is the minimum thickness.

In the present invention, the partition walls will sufficiently be cured by the post-exposure step (15) and will have durability against the solvent in the ink. Accordingly, curing by a postbaking step (16) may not necessarily be required. On the other hand, for the purpose of increasing the heat resistance of the partition walls or removing a volatile component from the partition walls, a postbaking step (16) is preferably employed after the post-exposure step.

Further, the present invention provides a process for producing a color filter, which comprises forming partition walls and pixels on a substrate by the above process.

Still further, the present invention provides a process for producing an organic EL device, which comprises forming partition walls and pixels on a substrate by the above process.

### EFFECTS OF THE INVENTION

According to the process of the present invention, it is possible to form partition walls excellent in the liquid repellency and pixels excellent in the uniformity in the thickness of an ink layer even when the exposure dose is low in the exposure step. Therefore, in a color filter or an organic EL device having partition walls and pixels formed by the process of the present invention, color mixing of inks is suppressed, and excellent uniformity in the thickness of an ink layer is achieved.

Unreacted residual molecules scarcely remain in the partition walls, and no migration takes place over a long period of time after forming the device, and the reliability of a device will not be lowered.

### BRIEF DESCRIPTION OF THE DRAWINGS

Fig. 1 is a surface observed image of partition walls and pixels obtained in Example 1 by an ultra deep shape measuring microscope.
Fig. 2 is a surface observed image of partition walls and pixels obtained in Example 6 by an ultra deep shape measuring microscope.
Fig. 3 is a cross-sectional image of partition walls obtained in Example 4 observed by a scanning electron microscope.

### MEANINGS OF SYMBOLS

1: Partition wall
2: Pixel
3: Film thickness profile of a cross-section along a line a-a of an ink layer
4: Film thickness profile of a cross-section along a line b-b of an ink layer

### BEST MODE FOR CARRYING OUT THE INVENTION

Now, the present invention will be described in further detail below. In the present specification, "%" means "mass%" unless otherwise specified.

First, in the process of the present invention, partition walls are formed by means of the following steps (11) to (15) (step (16) may optionally be employed), and pixels are formed by means of the following steps (21) and (22) (optionally a step (23) may be employed).

### STEP (11) OF COATING A SUBSTRATE WITH A PHOTOSENSITIVE COMPOSITION

First, the surface of a substrate is coated with the photosensitive composition of the present invention to form a coating film of the photosensitive composition. The photosensitive composition in the present invention will be described below.

As a coating method of the photosensitive composition, a spin coating method, a spray method, a slit coating method, a roll coating method or a bar coating method may, for example, be mentioned.

The thickness of the coating method varies depending on the material of the substrate and the purpose of use, and is preferably from 0.3 to 300 µm, more preferably from 1 to 60 µm.

As the substrate, its material is not particularly limited, but it may, for example, be various types of glass plates; a thermoplastic sheet of e.g. a polyester (such as polyethylene terephthalate), a polyolefin (such as polyethylene or polypropylene), a polycarbonate, a polymethyl methacrylate, a polysulfon, a polyimide or a poly(meth)acrylic resin; or a cured sheet of a thermosetting resin such as an epoxy resin or an unsaturated polyester resin. Especially, from the viewpoint of the heat resistance, a glass plate or a heat resistant plastic is preferably employed. Further, a transparent substrate is preferred, since the post-exposure is sometimes carried out from the rear side (the substrate side) on which no partition walls are formed.

Further, it is also possible to employ a substrate having a black matrix such as a metal black matrix or a resin black matrix formed thereon. In such a case, it is preferred to form partition walls on the black matrix.

Further, a substrate having a transparent electrode of e.g. indium tin oxide (ITO) or a metal wiring of e.g. chromium or molybdenum formed thereon may also be used.

### STEP (12) OF DRYING A COATING FILM OF THE PHOTOSENSITIVE COMPOSITION

Then, the coating film is vacuum dried or dried by heating to volatilize a diluting agent contained in the photosensitive composition. It is preferred to carry out vacuum drying and drying by heating in combination for efficient drying without non-uniformity in the outer appearance of the coating film. The conditions for the drying vary depending on the types of the respective components, the blend proportions, etc. for the photosensitive composition, and preferably, the vacuum drying is carried out within wide ranges of from 500 to 10 Pa for from about 10 to about 300 seconds, and the drying by heating is carried out within wide ranges of from 50 to 120°C for from about 10 to about 2,000 seconds.

### EXPOSURE STEP (13)

Then, a part of the coating film is subjected to exposure. Exposure is preferably carried out via a mask having a predescribed pattern. The light to be irradiated may, for example, be visible light; ultraviolet rays; far ultraviolet rays; an excimer laser such as KrF excimer laser, ArF excimer laser, F₂ excimer laser, Kr₂ excimer laser, KrAr excimer laser or Ar₂ excimer laser; X-rays; or electron beams.

Electromagnetic waves having a wavelength of from 100 to 600 nm are preferred, light having a distribution within a range of from 300 to 500 nm is more preferred, and i-line (365 nm), h-line (405 nm) or g-line (436 nm) is particularly preferred.

As an irradiation device, a known ultrahigh pressure mercury lamp or a deep UV lamp may, for example, be used. The exposure dose is preferably within a range of from 5 to 1,000 mJ/cm², more preferably from 50 to 400 mJ/cm², particularly preferably from 50 to 100 mJ/cm². If the exposure dose is at most 5 mJ/cm², curing of partition walls tends to be inadequate, and in the subsequent development, dissolution or peeling is likely to occur. If the exposure dose exceeds 1,000 mJ/cm², it tends to be difficult to obtain a high resolution.

### DEVELOPMENT STEP (14)

After the exposure step, development is carried out by a developer to remove a non-exposed portion. As the developer, it is possible to employ an aqueous alkali solution containing an alkali such as an inorganic alkali such as sodium hydroxide, potassium hydroxide, sodium carbonate, sodium silicate, sodium metasilicate or ammonia water; a primary amine such as ethylamine or n-propylamine; a secondary amine such as diethylamine or di-n-propylamine; a tertiary amine such as triethylamine, methyldiethylamine or N-methylpyrrolidone; an alcohol amine such as dimethylethanolamine or triethanolamine; a quaternary ammonium salt such as tetramethylammonium hydroxide, tetraethylammonium hydroxide or choline; or a cyclic amine such as pyrrole or piperidine. Further, it is also possible to use as the developer an aqueous solution comprising the above aqueous alkali solution and an appropriate amount of a water-soluble organic solvent such as methanol or ethanol, a surfactant or the like added.

The developing time (time during which the coating film is in contact with the developer) is preferably from 5 to 180 seconds. Further, the developing method may be any method such as a paddle method, a dipping method or a shower method. After the development, high pressure washing with water or washing with running water is carried out, followed by drying with compressed air or compressed nitrogen to remove moisture on the substrate.

### POST-EXPOSURE STEP (15)

Then, exposure is carried out again. The post-exposure is carried out preferably on the entire surface of the substrate. The post-exposure may be carried out from either the front side on which partition walls are formed or the rear side (the substrate side) on which no partition walls are formed. Otherwise, the exposure may be carried out from both the front and rear sides. In a case where partition walls are formed on a substrate on which a black matrix is formed, exposure is carried out preferably from the front side. The exposure dose is preferably at least 50 mJ/cm², more preferably at least 200 mJ/cm², furthermore preferably at least 1,000 mJ/cm², particularly preferably at least 2,000 mJ/cm². The exposure dose is preferably at most 3,000 mJ/cm².

As light to be applied, ultraviolet rays are preferred, and as a light source, a known ultrahigh pressure mercury lamp or high pressure mercury lamp may, for example, be used. Such a light source is preferably employed, since it emits light of at most 600 nm which contributes to curing of partition walls, and emission of light of at most 200 nm which causes decomposition by oxidation of partition walls is thereby little. Further, it is preferred that a quartz tube glass used for a mercury lamp has an optical filter function to shield light of at most 200 nm.

Otherwise, a low pressure mercury lamp may also be used as a light source. However, with a low pressure mercury lamp, the emission intensity of wavelength of at most 200 nm is high, and decomposition by oxidation of partition walls is likely to take place by formation of ozone, and accordingly, it is not desirable to carry out a large quantity of exposure. The exposure dose is preferably at most 500 mJ/cm², more preferably at most 300 mJ/cm².

### POSTBAKING STEP (16) OF SUBJECTING PARTITION WALLS TO HEAT TREATMENT

Then, it is preferred to subject the partition walls to heat treatment. Heat treatment may be carried out by a heating device such as a hot plate or an oven preferably at from 150 to 250°C for from 5 to 90 minutes. The heating temperature is more preferably at least 180°C. By subjecting the partition walls to heat treatment, chemical resistance of the partition walls will improve, whereby swelling of the partition walls by a solvent contained in an applied ink or bleeding of the ink can be prevented.

By the above photolithography process, partition walls can be obtained. In a case where the photosensitive composition of the present invention contains a black colorant, a function as a black matrix is imparted to partition walls to be formed.

The average of widths of the partition walls to be obtained is preferably at most 100 µm, more preferably at most 40 µm, particularly preferably at most 20 µm. The average of the widths of the partition walls is preferably at least 10 µm. The average of the heights of the partition walls is preferably from 0.05 to 50 µm, more preferably from 0.2 to 10 µm, particularly preferably from 0.5 to 3 µm.

The shape of the obtained partition walls is not particularly limited, and may be any of reverse tapered, rectangular and forward tapered shapes. Since only the upper surfaces of the partition walls have liquid repellency and the side surfaces of the partition walls have liquid affinity, an ink layer has an excellent uniformity regardless of the shape of the partition walls.

Further, the taper angle made by the side wall of a partition wall and the bottom of a partition wall is preferably from 30° to 150°. The contrast tends to decrease if the taper angle is too small or too large, such being unfavorable.

Further, the average of the widths of dots which are regions partitioned by partition walls is preferably at most 300 µm, more preferably at most 100 µm. The size (area) of each dot is preferably at least 5,000 µm² and at most 150,000 µm², more preferably at least 10,000 µm² and at most 120,000 µm², particularly preferably at least 15,000 µm² and at most 100,000 µm². If the size of the dots is too small, it tends to be difficult to drop an ink into desired dots by an ink jet. On the other hand, if the size of the dots is too large, the dropped ink will hardly uniformly spread in the dots.

Now, a method for forming pixels will be described.
STEP (21) OF INJECTING AN INK WITHIN DOTS WHICH ARE REGIONS PARTITIONED BY THE PARTITION WALLS

As an application method of injecting an ink, an ink jet method, a spray coating method, a screen printing method, a spin coating method, a slit coating method, a roll coating method or a bar coating method may, for example, be mentioned. Among them, an ink jet method, a spray coating method or a screen printing method is preferred since application is possible relatively easily even on a substrate having a large area, and further, an ink jet method is particularly preferred, with which layer formation with various inks is possible all at once.

As an ink jet apparatus, a piezo system or a thermal system may be mentioned depending on the ink discharge system, and it is preferred to use a piezo system apparatus. In the case of a thermal system, an ink is heated when it is discharged, whereby the ink may be degenerated by the heat, however, in the case of a piezo system, the ink will not be heated. The droplet of a liquid to be discharged is preferably from 5 to 500 pL. If the droplet is too small, the solvent may evaporate during flying of the ink, or the dropping accuracy may be decreased by the influence of a minute air current. If the droplet is too large, fine pixels may hardly be obtained.

### STEP (22) OF DRYING A COATING FILM OF THE INK

Then, a coating film of the ink is vacuum dried or dried by heating to volatilize the solvent. Further, it is preferred to carry out vacuum drying and drying by heating in combination for efficient drying without non-uniformity in the outer appearance. The conditions for the drying vary depending upon the types of the respective components, the blend proportions, etc., and preferably, the vacuum drying is carried out within wide ranges of from 10 to 500 Pa (absolute pressure) for from about 10 to about 300 seconds, and the drying by heating is carried out within wide ranges of from 50 to 120°C for from about 10 to about 2,000 seconds. In a case where the boiling point of the solvent in the ink to be used is low, vacuum drying or drying by heating is not necessarily carried out, and the coating film may be left at rest at room temperature for from about 10 to about 2,000 seconds.

### STEP (23) OF SUBJECTING AN INK LAYER TO HEAT TREATMENT

Then, heat treatment may be carried out by a heating device such as a hot plate or an oven preferably at from 150 to 250°C for from 5 to 90 minutes. By the heat treatment, in a case where the ink contains a thermosetting component, the curing reaction will be accelerated, and chemical resistance and heat resistance which are practically required can be imparted to the ink layer.

The size (area) of each pixel is preferably at least 5,000 µm² and at most 150,000 µm², more preferably at least 10,000 µm² and at most 120,000 µm², particularly preferably at least 15,000 µm² and at most 100,000 µm².

Now, the process for producing a color filter of the present invention will be described.

In a case where a color filter is produced by the process of the present invention, in order to impart a function as a black matrix to the partition walls, the photosensitive composition preferably contains a black colorant. In such a case, partition walls having a function as a black matrix are formed by the above steps for forming partition walls, and then pixels are formed by means of a coating step of injecting color inks of blue, green and red into regions partitioned by the partition walls by an ink jet method, a drying step and a heat treatment step.

Otherwise, a substrate having a black matrix preliminarily formed thereon may also be used. In such a case, partition walls are formed on a black matrix by the above method for forming partition walls, and then pixels are formed by means of a coating step (21) of injecting color inks of blue, green and red into dots which are regions partitioned by the partition walls, preferably by an ink jet method, a step (22) of drying a coating film of the ink, and a step (23) of subjecting an ink layer to heat treatment.

The shape of pixels to be formed may be of any known configuration such as a stripe type, a mosaic type, a triangle type or a 4-pixel configuration type.

Each of the color inks of blue, green and red mainly comprises a coloring component, a binder resin component and a solvent.

As the coloring component, it is preferred to employ a pigment or dye excellent in heat resistance, light resistance, etc.

As the binder resin component, a transparent resin excellent in heat resistance is preferred, such as an acrylic resin, a melamine resin or an urethane resin, but it is by no means restricted thereto.

In a case where the ink is a water-base ink, it comprises, as the solvent, water and, if necessary, a water-soluble organic solvent, and as the binder resin component, a water-soluble resin or a water-dispersible resin, and it contains various additives as the case requires.

In a case where the ink is an oil-base ink, it comprises an organic solvent as the solvent and a resin soluble in an organic solvent as the binder resin component, and it contains various additives as the case requires.

After forming pixels, an overcoat layer is preferably formed. The overcoat layer is formed for the purpose of improving the surface flatness and for the purpose of preventing an eluent from the ink at partition walls or pixels from reaching the liquid crystal layer. In a case where such an overcoat layer is to be formed, it is preferred to preliminarily remove the liquid repellency of the partition walls. In a case where the liquid repellency is not removed, the overcoating liquid will be repelled, and a uniform film thickness tends to be hardly obtainable. The method for removing the liquid repellency of partition walls may, for example, be plasma ashing treatment or optical ashing treatment.

Further, as the case requires, it is preferred to form a photospacer on the black matrix to improve the product quality of a liquid crystal panel to be produced by using a color filter.

In a case where a color filter is to be used for a liquid crystal panel, it is required to have both high brightness and high color purity. However, if the uniformity in the thickness of a color ink layer in the pixels is low, the brightness tends to decrease by the influence at a thick portion, and the color purity tends to decrease by the influence at a thin portion, as compared with an ideal flat film. Accordingly, to keep the product quality of a liquid crystal panel, it is preferred that (h1-h2)/h1<0.3, where h1 is the thickness at the thickest portion of one color ink layer in a color filter, and h2 is the thickness at the thinnest portion. When a color filter is produced by the process of the present invention, a color ink layer having a uniformity in the thickness, satisfying (h1-h2)/h1 <0.3 can be obtained. It is more preferred to obtain a color ink layer having a uniformity in the thickness satisfying (h1-h2)/h1<0.2.

Now, the process for producing an organic EL display device of the present invention will be described.

First, the transparent electrode of e.g. indium tin oxide (ITO) is formed by e.g. a sputtering method on a transparent substrate of e.g. glass, and if necessary, the transparent electrode is etched to have a desired pattern. Then, partition walls are formed by the process of the present invention. Then, by using an ink jet method, solutions of a hole transport material and a luminescent material are sequentially applied within dots among the partition walls and dried to form a hole transport layer and a luminescent layer.

As the hole transport material, for example, a coating liquid of a thiophene electroconductive polymer (PEDOT/PSS) may be used. Further, as the luminescent material, a π-conjugated polymer type luminescent material and a dye-containing polymer type luminescent material may be used. The π-conjugated polymer type luminescent material may, for example, be a polyfluorene (PF) derivative (red, green, blue), a poly-spiro derivative (red, green, blue), a polyparaphenylene derivative or a polythiophene derivative. The dye-containing polymer type luminescent material may, for example, be a dye-dispersed PVK (red, green, blue) which is a luminescent material having a phosphorescent or fluorescent low molecular weight dye dispersed in polyvinyl carbazole (PVK). As the solvent, it is preferred to use a highly polar solvent such as water as the solvent for the hole transport material, and it is preferred to use a low polar solvent such as xylene as the solvent for the luminescent material.

Then, an electrode of e.g. aluminum is formed by e.g. a vapor deposition method, whereby pixels for an organic EL display device will be obtained.

In a case where the thickness of the hole transport layer or the luminescent layer is uneven in the pixel, the electric field tends to gather at the thin portion, whereby deterioration of the material tends to be accelerated. Accordingly, in order to keep the product quality of an organic EL panel, it is preferred that (h1-h2)/h1<0.3, where h1 is the thickness at the thickest portion of the hole transport layer or the luminescent layer, and h2 is the thickness at the thinnest portion. When an organic EL device is produced by the process of the present invention, a hole transport layer or a luminescent layer having a uniformity in the thickness satisfying (h1-h2)/h1 <0.3 can be obtained. It is more preferred to obtain a hole transport layer or a luminescent layer having a uniformity in the thickness satisfying (h1-h2)/h1<0.2.

Now, the photosensitive composition which is a partition wall forming material in the present invention will be described.

With respect to the following specific compound name, a (meth)acryloyl group generically means both acryloyl group and methacryloyl group. A (meth)acrylate generically means both acrylate and methacrylate. (Meth)acrylic acid generically means both acrylic acid and methacrylic acid. Further, (meth)acrylamide generically means both acrylamide and methacrylamide.

In this specification, a group represented by the formula 1 will be referred to as a group (1). The same applies to other groups.

In this specification, a monomer represented by the formula (11) will be referred to as a monomer (11). The same applies to other monomers.

The polymer (A) in the present invention has a side chain containing a group (1) or a group (2) and a side chain containing an ethylenic double bond:

-CFXR^{f} (1)

wherein X is a hydrogen atom, a fluorine atom or a trifluoromethyl group, and R^{f} is an alkyl group having at most 20 carbon atoms which may have an etheric oxygen atom, at least one of hydrogen atoms of which is substituted by a fluorine atom, or a fluorine atom;

-(SiR¹R²O)ₙ-SiR¹R²R³ (2)

wherein each of R¹ and R² which are independent of each other, is a hydrogen atom, an alkyl group, a cycloalkyl group or an aryl group, R³ is a hydrogen atom or a C₁-₁₀ organic group, and n is an integer of from 1 to 200.

The side chain containing the group (1) or the group (2) may be directly formed by a polymerization reaction or may be formed by chemical exchange after the polymerization reaction. Further, a side chain containing an ethylenic double bond can be formed by chemical conversion after the polymerization reaction.

When R^{f} in the above formula 1 is an alkyl group having at most 20 carbon atoms which may have an etheric oxygen atom, at least one of hydrogen atoms of which is substituted by a fluorine atom, the hydrogen atoms in the alkyl group may be substituted by a halogen atom other than a fluorine atom. Such other halogen atom is preferably a chlorine atom. Further, the etheric oxygen atom may be present between the carbon-carbon bond in the alkyl group, or may be present at the terminal of the alkyl group. Further, the structure of the alkyl group may be a chain structure, a branched structure, a cyclic structure or a structure partially having a cyclic structure, and is preferably a chain structure.

As specific examples of the group represented by the above formula 1, the following may be mentioned.

-CF₃, -CF₂CF₃, -CF₂CHF₂, -(CF₂)₂CF₃, -(CF₂)₃CF₃, -(CF₂)₄CF₃, -(CF₂)₅CF₃, -(CF₂)₆CF₃, -(CF₂)₇CF₃, -(CF₂)₈CF₃, -(CF₂)₉CF₃, -(CF₂)₁₁CF₃, -(CF₂)₁₅CF₃, -CF(CF₃)O(CF₂)₅CF₃, -CF₂O(CF₂CF₂O)ₚCF₃ (p is an integer of from 1 to 8), -CF(CF₃)O(CF₂CF(CF₃)O)_{q}C₆F₁₃ (q is an integer of from 1 to 4), and -CF(CF₃)O(CF₂CF(CF₃)O)ᵣC₃F₇ (r is an integer of from 1 to 5).

The above group (1) is preferably a perfluoroalkyl group or a polyfluoroalkyl group containing one hydrogen atom, particularly preferably a perfluoroalkyl group (provided that the above alkyl group includes one having an etheric oxygen atom), whereby the partition walls to be formed from the photosensitive composition have good liquid repellency. Further, the above group (1) preferably has 4 to 6 carbon atoms in total. In such a case, sufficient liquid repellency will be imparted to the partition walls and in addition, the compatibility of the polymer (A) with other components constituting the photosensitive composition will be good, whereby when the photosensitive composition is applied to form a coating film, the polymer (A) molecules will not aggregate, and partition walls having good outer appearance will be formed.

In the above formula 2, a plurality of R^{1,}s and a plurality of R²'s in the respective siloxane units may be the same or different. Each of R¹ and R² is preferably a hydrogen atom, a C₁-₁₀ alkyl group, a cycloalkyl group or an aryl group, more preferably a hydrogen atom, a methyl group or a phenyl group, and particularly preferably R¹'s and R²'s in all the siloxane units are methyl groups, whereby partition walls to be formed from the photosensitive composition have excellent ink falling property. Further, in a case where R³ is an organic group, it may contain a nitrogen atom, an oxygen atom or the like, and R³ is preferably a hydrogen atom or a C₁₋₅ hydrocarbon group. n is preferably an integer of from 1 to 100, more preferably an integer of from 2 to 80.

The ethylenic double bond may, for example, be an addition-polymerizable unsaturated group such as a (meth)acryloyl group, an allyl group, a vinyl group or a vinyl ether group. Some or all of hydrogen atoms in such a group may be substituted by a hydrocarbon group. The hydrocarbon group is preferably a methyl group.

The polymer (A) can be prepared by copolymerizing at least two monomers including a monomer (a1) containing the group (1) or a monomer (a2) containing a group (2) and a monomer (a3) containing a reactive group and then reacting the obtained copolymer with a compound (z1) containing a functional group capable of being bonded with the above reactive group and an ethylenic double bond.

The monomer (a1) containing the group (1) is preferably a monomer represented by the following formula 11.

CH₂=CR⁴COO-Y-CFXR^{f} (11)

wherein R⁴ is a hydrogen atom, a fluorine atom, a chlorine atom, a bromine atom, an iodine atom, a methyl group or a trifluoromethyl group, Y is a single bond or a C₁₋₆ bivalent organic group containing no fluorine atom, and R^{f} is an alkyl group having at most 20 carbon atoms which may contain an etheric oxygen atom, at least one of hydrogen atoms of which is substituted by a fluorine atom, or a fluorine atom.

In the monomer (11), the preferred embodiment of -CFXR^{f} is as defined for the group (1). In the monomer (11), Y is preferably a C₂₋₄ alkylene group in view of the availability.

As examples of the monomer (11), the following may be mentioned.

CH₂=CR⁴COOR⁵CFXR^{f}

CH₂=CR⁴COOR⁵NR⁶SO₂CFXR^{f}

CH₂=CR⁴COOR⁵NR⁶COCFXR^{f}

CH₂=CR⁴COOCH₂CH(OH)R⁷CFXR^{f}

In the above formulae, R⁴ is a hydrogen atom, a fluorine atom, a chlorine atom, a bromine atom, an iodine atom, a methyl group or a trifluoromethyl group, R⁵ is a C₁₋₆ alkylene group, R⁶ is a hydrogen atom or a methyl group, R⁷ is a single bond or a C₁₋₄ alkylene group, and R^{f} is as defined above.

Specific examples of R⁵ may, for example, be -CH₂-, -CH₂CH₂-, -CH(CH₃)-, -CH₂CH₂CH₂-,-(C(CH₃)₂-, -CH(CH₂CH₃)-, -CH₂ CH₂CH₂CH₂-, -CH(CH₂CH₂CH₃)-, -CH₂(CH₂)₃CH₂- and - CH(CH₂CH(CH₃)₂)-.

Specific examples of R⁷ may, for example, be -CH₂-, -CH₂CH₂-, -CH(CH₃)-, -CH₂CH₂CH₂-, - (C(CH₃)₂-, -CH(CH₂CH₃)-, -CH₂ CH₂CH₂CH₂- and -CH(CH₂CH₂CH₃)-.

Specific examples of the monomer (11) may, for example, be 2-(perfluorohexyl)ethyl (meth)acrylate and 2-(perfluorobutyl)ethyl (meth)acrylate. The monomers (11) may be used alone or in combination as a mixture of two or more of them.

The monomer (a2) containing the group (2) is preferably the following monomer (21):

CH₂=CR⁸COO-Z-(SiR¹R²O)ₙ-SiR¹R²R³ (21)

wherein R⁸ is a hydrogen atom or a methyl group, Z is a single bond or a C₁₋₆ bivalent organic group, each of R¹ and R² which are independent of each other, is a hydrogen atom, an alkyl group, a cycloalkyl group or an aryl group, R³ is a hydrogen atom or a C₁₋₁₀ organic group, and n is an integer of from 1 to 200.

In the monomer (a21), the preferred embodiment of R¹, R², R³ and n is as defined for the above group (2).

Z is preferably a C₁-₆ bivalent hydrocarbon group. As specific examples, the following may be mentioned.

-CH₂-, -CH₂CH₂-, -CH(CH₃)-,

-CH₂CH₂CH₂-, -C(CH₃)₂-, -CH(CH₂CH₃)-,

-CH₂CH₂CH₂CH₂-, -CH(CH₂CH₂CH₃)-,

-CH₂(CH₂)₃CH₂-, -CH(CH₂CH(CH₃)₂)-, etc.

The above monomers (21) may be used alone or in combination as a mixture of two or more of them.

The monomer (a3) containing a reactive group may, for example, be a monomer containing a hydroxy group, an acid anhydride monomer containing an ethylenic double bond, a monomer containing a carboxy group or a monomer containing an epoxy group. Here, the monomer (a3) preferably contains substantially no group (1) nor the group (2).

After the copolymerization, the reactive group of the monomer (a3) will be reacted with a compound (z1) containing a functional group capable of being bonded with the above reactive group and an ethylenic double bond, to form a polymer (A) having a side chain containing an ethylenic double bond.

Specific examples of the monomer containing a hydroxy group may, for example, be 2-hydroxyethyl (meth)acrylate, 2-hydroxypropyl (meth)acrylate, 3-hydroxypropyl (meth)acrylate, 4-hydroxybutyl (meth)acrylate, 5-hydroxypentyl (meth)acrylate, 6-hydroxyhexyl (meth)acrylate, 4-hydroxycyclohexyl (meth)acrylate, neopentyl glycol mono(meth)acrylate, 3-chloro-2-hydroxypropyl (meth)acrylate, glycerol mono(meth)acrylate, 2-hydroxyethyl vinyl ether, 4-hydroxybutyl vinyl ether, cyclohexanediol monovinyl ether, 2-hydroxyethyl allyl ether, N-hydroxymethyl (meth)acrylamide and N,N-bis(hydroxymethyl) (meth)acrylamide.

Further, the monomer containing a hydroxy group may be a monomer having a polyoxyalkylene chain with a terminal hydroxy group. It may, for example, be CH₂=CHOCH₂C₆H₁₀CH₂O(C₂H₄O)ₖH (wherein k is an integer of from 1 to 100, the same applies hereinafter), CH₂=CHOC₄H₈O(C₂H₄O)ₖH, CH₂=CHCOOC₂H₄O(C₂H₄O)ₖH, CH₂=C(CH₃)COOC₂H₄O(C₂H₄O)ₖH or CH₂=CHCOOC₂H₄O(C₂H₄O)ₘ(C₃H₆O)ⱼH (wherein m is 0 or an integer of from 1 to 100, and j is an integer of from 1 to 100, provided that m+j is from 1 to 100, the same applies hereinafter), or CH₂=C(CH₃)COOC₂H₄O(C₂H₄O)ₘ(C₃H₆O)ⱼH.

Specific examples of the acid anhydride monomer containing an ethylenic double bond may, for example, be maleic anhydride, itaconic anhydride, citraconic anhydride, methyl-5-norbornene-2,3-dicarboxylic anhydride, 3,4,5,6-tetrahydrophthalic anhydride, cis-1,2,3,6-tetrahydrophthalic anhydride and 2-buten-1-yl succinic anhydride.

Specific examples of the monomer containing a carboxy group may, for example, be acrylic acid, methacrylic acid, vinyl acetic acid, crotonic acid, itaconic acid, maleic acid, fumaric acid, cinnamic acid and their salts.

Specific examples of the monomer containing an epoxy group may, for example, be glycidyl (meth)acrylate and 3,4-epoxycyclohexylmethyl acrylate.

The polymer (A) preferably further has a side chain containing an acidic group. Some molecules of the polymer (A) not cured in the exposure step will be washed off from the surface of the partition walls in the development step, as they have the side chain containing an acidic group, whereby the residual molecules not fixed in the partition walls will scarcely remain. It is thereby possible to further reduce molecules which may otherwise migrate to dots between the partition walls at a stage prior to the post-exposure step, whereby the liquid affinity of the dots will be higher.

As the acidic group, at least one acidic group selected from the group consisting of a carboxy group, a phenolic hydroxy group and a sulfonic acid group is preferred.

The side chain containing an acidic group may be formed by the polymerization reaction of the monomer (a4) containing an acidic group or may be formed by a chemical conversion after the polymerization reaction.

The monomer (a4) containing an acidic group may, for example, be a monomer containing a carboxy group, a monomer containing a phenolic hydroxy group or a monomer containing a sulfonic acid group. In a case where a monomer containing a carboxy group is used as the monomer (a4) containing an acidic group, and a monomer containing a carboxy group is used also as the above-mentioned monomer (a3) having a reactive group, one having no ethylenic double bond finally introduced and having a residual carboxy group, will be deemed to be the monomer (a4).

The monomer containing a phenolic hydroxy group may, for example, be o-hydroxystyrene, m-hydroxystyrene or p-hydroxystyrene. Or, it may be a monomer having at least one hydrogen atom in such a benzene ring substituted by an alkyl group such as a methyl group, an ethyl group or a n-butyl group; an alkoxy group such as a methoxy group, an ethoxy group or a n-butoxy group; a halogen atom; a haloalkyl group having at least one hydrogen atom of an alkyl group substituted by a halogen atom; a nitro group; a cyano group; or an amide group.

The monomer containing a sulfonic acid group may be vinyl sulfonic acid, styrene sulfonic acid, (meth)allyl sulfonic acid, 2-hydroxy-3-(meth)allyloxypropane sulfonic acid, 2-sulfoethyl (meth)acrylate, 2-sulfopropyl (meth)acrylate, 2-hydroxy-3-(meth)acryloxypropane sulfonic acid or 2-(meth)acrylamide-2-methylpropane sulfonic acid.

The monomer to be used for the polymerization in the present invention may contain a monomer (a5) other than the monomer (a1) containing the group (1), the monomer (a2) containing the group (2), the monomer (a3) containing a reactive group and the monomer (a4) containing an acidic group.

Such other monomer (a5) may be a hydrocarbon type olefin, a vinyl ether, an isopropenyl ether, an allyl ether, a vinyl ester, an allyl ester, a (meth)acrylate, a (meth)acrylamide, an aromatic vinyl compound, a chloroolefin or a conjugated diene. Such a compound may contain a functional group, and the functional group may, for example, be a carbonyl group or an alkoxy group. A (meth)acrylate or a (meth)acrylamide is particularly preferred, since the heat resistance of the partition walls will thereby be excellent.

The polymer (A) may be prepared, for example, by the following method. Firstly, the monomers are dissolved in a solvent and heated, and a polymerization initiator is added to carry out copolymerization. In the copolymerization reaction, a chain transfer agent may preferably be present, as the case requires. The monomers, the polymerization initiator, the solvent and the chain transfer agent may continuously be added.

The above solvent may, for example, be an alcohol such as ethanol, 1-propanol, 2-propanol, 1-butanol or ethylene glycol; a ketone such as acetone, methyl isobutyl ketone or cyclohexanone; a cellosolve such as 2-methoxyethanol, 2-ethoxyethanol or 2-butoxyethanol; a carbitol such as 2-(2-methoxyethoxy)ethanol, 2-(2-ethoxyethoxy)ethanol or 2-(2-butoxyethoxy)ethanol; an ester such as methyl acetate, ethyl acetate, n-butyl acetate, ethyl lactate, n-butyl lactate, ethylene glycol monomethyl ether acetate, propylene glycol monomethyl ether acetate, ethylene glycol diacetate or glycerol triacetate; diethylene glycol dimethyl ether or diethylene glycol methylethyl ether.

As the polymerization initiator, a known organic peroxide, an inorganic peroxide, or an azo compound may, for example, be mentioned. The organic peroxide and the inorganic peroxide may be used in combination with a reducing agent in the form of a redox catalyst.

The organic peroxide may, for example, be benzoyl peroxide, lauroyl peroxide, isobutyryl peroxide, t-butyl hydroperoxide or t-butyl-α-cumyl peroxide. The inorganic peroxide may, for example, be ammonium persulfate, sodium persulfate, potassium persulfate, hydrogen peroxide or a percarbonate. The azo compound may, for example, be 2,2'-azobisisobutyronitrile, 1,1'-azobis(cyclohexane-1-carbonitrile), 2,2'-azobis(2,4-dimethylvaleronitrile), 2,2'-azobis(4-methoxy-2,4-dimethylvaleronitrile), dimethyl 2,2'-azobisisobutyrate or 2,2'-azobis(2-amidinopropane)dihydrochloride.

The chain transfer agent may, for example, be a mercaptan such as n-butylmercaptan, n-dodecylmercaptan, t-butylmercaptan, ethyl thioglycolate, 2-ethylhexyl thioglycolate or 2-mercaptoethanol; or an alkyl halide such as chloroform, carbon tetrachloride or carbon tetrabromide.

The copolymer obtained as described above is reacted with a compound (z1) containing a functional group capable of being bonded with the reactive group and an ethylenic double bond to obtain the polymer (A).

The following combinations may, for example, be mentioned as a combination of a reactive group to the compound (z1) containing a functional group capable of being bonded with the reactive group and an ethylenic double bond.
(1) A hydroxy group to an acid anhydride containing an ethylenic double bond.
(2) A hydroxy group to a compound containing an isocyanate group and an ethylenic double bond.
(3) A hydroxy group to a compound containing a chlorinated acyl group and an ethylenic double bond.
(4) An acid anhydride to a compound containing a hydroxy group and an ethylenic double bond.
(5) A carboxy group to a compound containing an epoxy group and an ethylenic double bond.
(6) An epoxy group to a compound containing a carboxy group and an ethylenic double bond.

As specific examples for the acid anhydride containing an ethylenic double bond, the above-mentioned examples may be mentioned. As specific examples for the compound containing an isocyanate group and an ethylenic double bond, 2-(meth)acryloyloxyethyl isocyanate and 1,1-bis((meth)acryloyloxymethyl)ethyl isocyanate may be mentioned. As a specific example for the compound containing a chlorinated acyl group and an ethylenic double bond, (meth)acryloyl chloride may be mentioned. As specific examples for the compound containing a hydroxy group and an ethylenic double bond, the above-mentioned examples for the monomer containing a hydroxy group may be mentioned. As specific examples for the compound containing an epoxy group and an ethylenic double bond, the above-mentioned examples for the monomer containing an epoxy group may be mentioned. As specific examples for the compound containing a carboxy group and an ethylenic double bond, the above-mentioned examples for the monomer containing a carboxy group may be mentioned.

As the above combination, particularly preferred is a combination of a hydroxy group to 1,1-bis((meth)acryloyloxymethyl)ethyl isocyanate, whereby the polymer (A) has a side chain containing at least 2 ethylenic double bonds per one side chain, and the polymer (A) thereby has excellent fixing property to the surface of partition walls.

When the copolymer is reacted with the compound (z1) containing a functional group capable of being bonded with the reactive group and an ethylenic double bond, the solvent exemplified in the above-described preparation of the copolymer may be used as the solvent to be used for the reaction.

Further, a polymerization inhibitor may preferably be blended. The polymerization inhibitor may, for example, be 2,6-di-t-butyl-p-cresol.

Further, a catalyst or a neutralizing agent may be added. For example, in a case where a copolymer having a hydroxy group is to be reacted with a compound containing an isocyanate group and an ethylenic double bond, a tin compound or the like may be used. In a case where a copolymer containing a hydroxy group is to be reacted with a compound containing a chlorinated acyl group and an ethylenic double bond, a basic catalyst may be used.

The preferred proportion of each monomer based on the total mass of monomers to be copolymerized is as follows. In the case of using the monomer (a1) containing the group (1), its proportion is preferably from 20 to 80 mass%, more preferably from 30 to 60 mass%. In the case of using the monomer (a2) containing the group (2), its proportion is preferably from 0.01 to 20 mass%, more preferably from 0.05 to 10 mass%. As the proportion of the group (1) or the group (2) is high, the polymer (A) of the present invention will be excellent in the effect to lower the surface tension of the partition walls made of a coating film cured product to be formed, and a high liquid repellency will be imparted to the partition walls. On the other hand, if the proportion is too high, the adhesion between the partition walls and the substrate tends to be low. The proportion of the monomer (a3) containing a reactive group is preferably from 20 to 70 mass%, more preferably from 30 to 50 mass%. Within such a range, the polymer (A) will have good developability and fixing property to partition walls. The proportion of the monomer (a4) containing an acidic group is preferably from 2 to 20 mass%, more preferably from 4 to 12 mass%. Within such a range, the residual molecules not fixed in the exposure step will be readily washed off from the partition walls in the development step. The proportion of other monomer (a5) is preferably at most 70 mass%, more preferably at most 50 mass%. Within such a range, the alkali solubility and the developability will be good.

It is preferred that the copolymer and the compound (z1) are charged so that the equivalent ratio of [functional group of the compound (z1)]/[reactive group of the copolymer] would be from 0.5 to 2.0. As the equivalent ratio is high, the polymer (A) will have good fixing property to partition walls. On the other hand, if the equivalent ratio is too high, an impurity as an unreacted compound (z1) increases, whereby the appearance of a coating film will be deteriorated. The equivalent ratio is more preferably from 0.8 to 1.5. Further, in a case where a monomer having a carboxy group is used for both of the monomer (a3) containing a reactive group and the monomer (a4) containing an acidic group, the amounts of the copolymer and the compound (z1) to be charged may be adjusted so that the acid value of the polymer (A) is an aimed value.

In a case where the polymer (A) has the group (1), the content of fluorine atoms of the polymer (A) is preferably from 5 to 35 mass%. The higher the content, the more the polymer (A) will be excellent in the effect to lower the surface tension of the partition walls, and the higher the liquid repellency to be imparted to the partition walls. On the other hand, if the content is too high, the adhesion between the partition walls and the substrate tends to be low. The content of fluorine atoms of the polymer (A) is more preferably such that the lower limit is 10 mass%, and the upper limit is 30 mass%.

In a case where the polymer (A) has the group (2), the content of silicon atoms of the polymer (A) is preferably from 0.5 to 30 mass%. The higher the content, the more the polymer (A) will impart an effect to lower the surface tension of the partition walls and an effect to improve the ink falling property. On the other hand, if the content is too high, the adhesion between the partition walls and the substrate tends to be low. The content of silicon atoms of the polymer (A) is more preferably such that the lower limit is 0.5 mass% and the upper limit is 10 mass%.

The polymer (A) preferably has at least 2 and at most 100, more preferably at least 6 and at most 50 ethylenic double bonds in its molecule. Within such a range, the polymer (A) will have good developability and fixing property to partition walls.

The acid value of the polymer (A) is preferably at most 100 (mgKOH/g), more preferably from 10 to 50 (mgKOH/g). Within such a range, the residual molecules not fixed in the exposure step will be readily washed off from the partition walls in the development step. Here, the acid value is the mass (unit: mg) of potassium hydroxide required to neutralize 1 g of the resin, and in this specification, the unit is identified by mgKOH/g.

The weight average molecular weight of the polymer (A) is preferably at least 500 and less than 15,000, more preferably at least 1,000 and less than 10,000. Within such a range, the alkali solubility and the developability are good.

In the present invention, the proportion of the polymer (A) in the total solid content of the photosensitive composition is preferably from 0.1 to 30 mass%. When such a proportion is high, the polymer (A) will be excellent in the effect to lower the surface tension of the partition walls to be formed, and a high liquid repellency will be imparted to the partition walls. On the other hand, if the proportion is too high, the adhesion between the partition walls and the substrate tends to be low. The proportion of the polymer (A) in the total solid content of the composition is more preferably such that the lower limit is 0.15 mass% and the upper limit is 20 mass%.

The polymer (A) in the present invention may have both side chain containing the group (1) and side chain containing the group (2) in one molecule. Further, the photosensitive composition of the present invention may contain both polymer (A) having a side chain containing the group (1) and polymer (A) having a side chain containing the group (2). In such cases, the photosensitive composition simultaneously has particularly high liquid repellency and high ink falling property.

The photosensitive composition of the present invention preferably contains an alkali soluble photosensitive resin (B). The alkali soluble photosensitive resin (B) preferably contains an acidic group and an ethylenic double bond in one molecule. As the alkali soluble photosensitive resin (B) contains an acidic group, the non-exposed portion will be removed by an alkali developer. Further, as it contains an ethylenic double bond, the exposed portion will not be removed by an alkali developer. Accordingly, partition walls can be formed. The alkali soluble photosensitive resin (B) preferably contains substantially no group (1) nor group (2).

The acidic group may be at least one acidic group selected from the group consisting of a carboxy group, a phenolic hydroxy group, a sulfonic acid group and a phosphoric acid group. The ethylenic double bond may, for example, be an addition-polymerizable unsaturated group such as a (meth)acryloyl group, an allyl group, a vinyl group or a vinyl ether group. Some or all of hydrogen atoms in such a group may be substituted by a hydrocarbon group. The hydrocarbon group is preferably a methyl group.

The alkali soluble photosensitive resin (B) may, for example, be a polymer (B-1) having a side chain containing an acidic group and a side chain containing an ethylenic double bond, or a resin (B-2) having an ethylenic double bond and an acidic group introduced to an epoxy resin, each being a copolymer of monomers containing an ethylenic double bond.

The above polymer (B-1) may be prepared in the same manner as in the preparation of the above polymer (A) except that the monomer (a1) containing the group (1) or the monomer (a2) containing the group (2) is not used. As an ethylenic unsaturated monomer containing a phosphoric acid group, 2-(meth)acryloyloxyethane phosphoric acid may be mentioned.

The above resin (B-2) is preferably a compound obtained by reacting a reaction product of an epoxy resin with a compound containing a carboxy group and an ethylenic double bond, with a polybasic carboxylic acid or its anhydride.

The epoxy resin to be used for preparation of the resin (B-2) may, for example, be a bisphenol A type epoxy resin, a bisphenol F type epoxy resin, a phenol novolac type epoxy resin, a cresol novolac type epoxy resin, a trisphenolmethane type epoxy resin, an epoxy resin having a naphthalene skeleton, an epoxy resin having a biphenyl skeleton represented by the following formula (B-21) (provided that s is from 2 to 50, preferably from 2 to 10) or an epoxy resin represented by the following formula (B-22) (provided that each of R⁷, R⁸, R⁹ and R¹⁰ which are independent of one another, is a hydrogen atom, a chlorine atom or a C₁₋₅ alkyl group, and t is from 0 to 10).

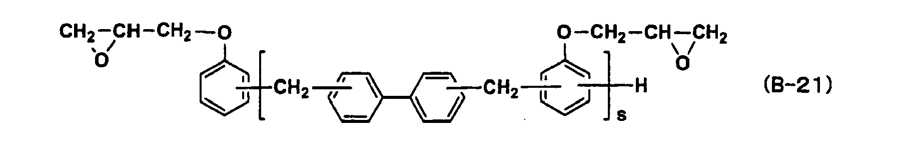

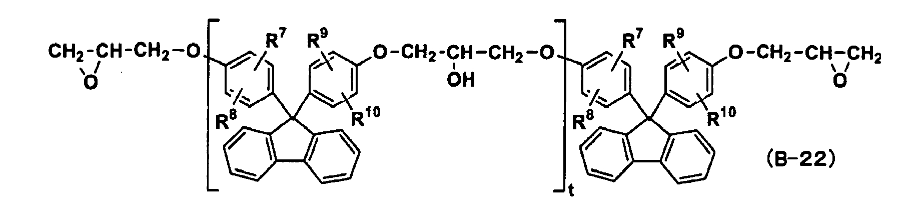

An ethylenic double bond is introduced to an epoxy resin by reacting a compound containing a carboxy group and an ethylenic double bond with the epoxy resin. Further, by reacting a polybasic carboxylic acid or its anhydride therewith, it is possible to introduce the carboxy group as an acidic group. Especially, in a case where the compound containing a carboxy group and an ethylenic double bond is reacted with the epoxy resin represented by the above formula (B-22), and then a polybasic carboxylic anhydride is reacted therewith, it is preferred to react a mixture of dicarboxylic anhydride and tetracarboxylic dianhydride. It is thereby possible to control a molecular weight by changing the ratio of dicarboxylic anhydride and tetracarboxylic dianhydride.

Commercial products of the resin (B-2) having an ethylenic double bond and an acidic group introduced to the epoxy resin may, for example, be KAYARAD PCR-1069, K-48C, CCR-1105, CCR-1115, CCR-1163H, CCR-1166H, CCR-1159H, TCR-1025, TCR-1064H, TCR-1286H, ZAR-1535H, ZFR-1122H, ZFR-1124H, ZFR-1185H, ZFR-1492H, ZCR-1571H, ZCR1569H, ZCR-1580H, ZCR1581H and ZCR1588H (all manufactured by NIPPON KAYAKU CO., LTD.).

The acid value of the alkali soluble photosensitive resin (B) is preferably from 10 to 300 mgKOH/g, more preferably from 30 to 150 mgKOH/g. Within such a range, the alkali solubility and the developability of the photosensitive composition will be good.

The alkali soluble photosensitive resin (B) preferably has at least three ethylenic double bonds in one molecule, more preferably at least 6 ethylenic double bonds in one molecule. It is thereby possible that the difference in alkali solubility may readily be made between an exposed portion and a non-exposed portion, and it becomes possible to form a fine pattern with a lower exposure dose.

The weight average molecular weight of the alkali soluble photosensitive resin (B) is preferably at least 500 and less than 20,000, more preferably at least 2,000 and less than 15,000. Within such a range, the alkali solubility and the developability of the photosensitive composition will be good.

The alkali soluble photosensitive resin (B) preferably further has a carboxy group or a hydroxy group as a crosslinkable group. In a case where the photosensitive composition of the present invention further contains a thermosetting agent (E) which is a compound having at least two groups capable of reacting with a carboxy group or a hydroxy group, such a thermosetting resin undergoes a crosslinking reaction with the alkali soluble photosensitive resin (B) by heat treatment after the development, whereby the crosslinked density of the partition walls will increase, and the heat resistance will be improved. The carboxy group or the phenolic hydroxy group as an acidic group is also a crosslinkable group. In a case where the alkali soluble photosensitive resin (B) has a sulfonic acid group or a phosphoric acid group, as an acidic group, it preferably has at least one of a carboxy group, a phenolic hydroxy group and an alcoholic hydroxy group, as a crosslinkable group.

The proportion of the alkali soluble photosensitive resin (B) in the total solid content of the photosensitive composition is preferably from 5 to 80 mass%, more preferably from 10 to 60 mass%. Within such a range, the alkali developability of the photosensitive composition will be good.

The photosensitive composition of the present invention preferably contains a photopolymerization initiator (C). The photopolymerization initiator (C) preferably comprises a compound which emits radicals by light.

The photopolymerization initiator (C) may, for example, be an α-diketone such as benzyl, diacetyl, methylphenylglyoxylate or 9,10-phenanthrenequinone; an acyloin such as benzoin; an acyloin ether such as benzoin methyl ether, benzoin ethyl ether or benzoin isopropyl ether; a thioxanthone such as thioxanthone, 2-chlorothioxanthone, 2-methylthioxanthone, 2,4-dimethylthioxanthone, isopropylthioxanthone, 2,4-diethylthioxanthone, 2,4-dichlorothioxanthone, 2,4-diisopropylthioxanthone or thioxanthone-4-sulfonic acid; a benzophenone such as benzophenone, 4,4'-bis(dimethylamino)benzophenone or 4,4'-bis(diethylamino)benzophenone; an acetophenone such as acetophenone, 2-(4-toluenesulfonyloxy)-2-phenylacetophenone, p-dimethylaminoacetophenone, 2,2'-dimethoxy-2-phenylacetophenone, p-methoxyacetophenone, 2-methyl-[4-(methylthio)phenyl]-2-morpholino-1-propanone or 2-benzyl-2-dimethylamino-1-(4-morpholinophenyl)-butan-1-on; a quinone such as anthraquinone, 2-ethylanthraquinone, camphorquinone or 1,4-naphthoquinone; an aminobenzoate such as ethyl 2-dimethylaminobenzoate, ethyl 4-dimethylaminobenzoate, (n-butoxy)ethyl 4-dimethylaminobenzoate, isoamyl 4-dimethylaminobenzoate or 2-ethylhexyl 4-dimethylaminobenzoate; a halogen compound such as phenacyl chloride or trihalomethyl phenyl sulfone; an acylphosphineoxide; a peroxide such as di-t-butylperoxide; or an oxime ester such as 1,2-octanedione, 1-[4-(phenylthio)-, 2-(o-benzoyloxime) or ethanone 1-[9-ethyl-6-(2-methylbenzoyl)-9H-carbazoyl-3-yl]-1-(o-acetyloxime).

Such photopolymerization initiators may be used alone or in combination as a mixture of two or more of them. Particularly, the above-mentioned aminobenzoate, the above-mentioned benzophenone or the like may be used together with another photoradical-forming agent to exhibit a sensitizing effect. Further, an aliphatic amine such as triethanolamine, methyldiethanolamine, triisopropanolamine, n-butylamine, N-methyldiethanolamine or diethylaminoethyl methacrylate may likewise be used together with a photoradical-forming agent to exhibit a sensitizing effect.

The proportion of the photopolymerization initiator (C) in the total solid content in the photosensitive composition is preferably from 0.1 to 50 mass%, more preferably from 0.5 to 30 mass%. Within such a range, the sensitivity of the photosensitive composition will be good.

The photosensitive composition preferably contains a radical crosslinking agent (D) containing at least two ethylenic double bonds and containing no acidic group, whereby the light curing property of the photosensitive composition will improve, and formation of partition walls with a low exposure dose will be accelerated.

Specific examples of the radical crosslinking agent (D) may, for example, be diethylene glycol di(meth)acrylate, tetraethylene glycol di(meth)acrylate, tripropylene glycol di(meth)acrylate, neopentyl glycol di(meth)acrylate, 1,9-nonanediol di(meth)acrylate, trimethylolpropane tri(meth)acrylate, pentaerythritol tri(meth)acrylate, pentaerythritol tetra(meth)acrylate, ditrimethylolpropane tetra(meth)acrylate, dipentaerythritol hexa(meth)acrylate and urethane acrylate. They may be used alone or in combination as a mixture of two or more of them.

The proportion of the radical crosslinking agent (D) in the total solid content in the photosensitive composition, is preferably from 10 to 60 mass%, more preferably from 15 to 50 mass%. Within such a range, the alkali developability of the photosensitive composition will be good.

The photosensitive composition preferably contains a thermosetting agent (E), as the case requires. It is thereby possible to improve the heat resistance and water permeation resistance of the partition walls.

The thermosetting agent (E) may, for example, be an amino resin, a compound having at least two epoxy groups, a compound having at least two hydrazino groups, a polycarbodiimide compound, a compound having at least two oxazoline groups, a compound having at least two aziridine groups, a polyvalent metal, a compound having at least two mercapto groups or a polyisocyanate compound.

Among the above thermosetting agents (E), an amino resin, a compound having at least two epoxy groups or a compound having at least two oxazoline groups is particularly preferred, whereby chemical resistance of the formed partition walls will be improved.

The proportion of the thermosetting agent (E) in the total solid content of the photosensitive composition is preferably from 1 to 50 mass%, more preferably from 5 to 30 mass%. Within such a range, the alkali developability of the photosensitive composition will be good.

The photosensitive composition of the present invention preferably contains a silane coupling agent (F) as the case requires, whereby it is possible to improve the adhesion of the partition walls to the substrate.

Specific examples of the silane coupling agent may, for example, be tetraethoxysilane, 3-glycidoxypropyltrimethoxysilane, methyltrimethoxysilane, vinyltrimethoxysilane, 3-methacryloyloxypropyltrimethoxysilane, 3-chloropropyltrimethoxysilane, 3-mercaptopropyltrimethoxysilane, N-phenyl-3-aminopropyltrimethoxysilane, heptadecafluorooctylethyltrimethoxysilane, a polyoxyalkylene chain-containing triethoxysilane and imidazole silane. They may be used alone or in combination as a mixture of two or more of them.

Further, for the photosensitive composition, as the case requires, a colorant (G) may be used, whereby partition walls can be colored.

To prepare a black photosensitive composition to form partition walls as a black matrix, it is possible to use, for example, carbon black, aniline black, anthraquinone black pigment or perylene black pigment, e.g. specifically, C. I. Pigment Black 1, 6, 7, 12, 20 or 31. It is also possible to use a mixture of organic or inorganic pigments of e.g. red, blue and green pigments.

As the black pigment, carbon black is preferred from the viewpoint of the price and good light shielding properties. Such carbon black may be surface-treated with e.g. a resin. Further, in order to adjust the color tone, a blue pigment or a purple pigment may be used in combination.

The carbon black is preferably one having a specific surface area of from 50 to 200 m²/g as measured by BET method. If carbon black having a specific surface area of less than 50 m²/g is used, the coloring power of the partition walls (black matrix) tends to decrease, and it is thereby necessary to blend a large amount of carbon black in order to obtain desired shielding properties, and if carbon black having a specific surface area exceeding 200 m²/g is used, a dispersion aid is likely to be excessively adsorbed on the carbon black, whereby it will be required to incorporate a large amount of a dispersion aid in order to obtain various physical properties.

Further, the carbon black is preferably one having dibutyl phthalate oil absorption of at most 120 cc/100 g from the viewpoint of the sensitivity to light. The smaller the oil absorption, the better.

Further, the average particle size of carbon black by a laser diffraction scattering method is preferably such that the lower limit is at least 40 nm, and the upper limit is at most 200 nm. If the average particle size is too small, dispersion at a high concentration tends to be difficult, and accordingly, a photosensitive composition having good stability with time will hardly be obtained. If the average particle size is too large, the linearity of the pattern may be deteriorated.

The proportion of a colorant (G) in the total solid content of the photosensitive composition is preferably from 15 to 50 mass%, more preferably from 30 to 40 mass%. If the content is low, no desired light shielding properties will be obtained, and if it is high, the sensitivity or the resolution may be decreased. Thus, the above range is preferred.

To the photosensitive composition, a curing accelerator, a thickener, a plasticizer, a defoaming agent, a leveling agent, an anti-repellent, an ultraviolet absorber, etc. may be incorporated, as the case requires.

The photosensitive composition is preferably applied on a substrate after a diluting agent is added thereto.

As the diluting agent, various monomers exemplified in the description of the polymer (A) may be used as a reactive diluting agent. Further, solvents exemplified in the description of the solvent to be used for the preparation of the polymer (A) may be used. In addition, a linear hydrocarbon such as n-butane or n-hexane, a cyclic saturated hydrocarbon such as cyclohexane, or an aromatic hydrocarbon such as toluene, xylene or benzyl alcohol may, for example, be mentioned. They may be used alone or in combination as a mixture of two or more of them.

It is possible to use the photosensitive composition of the present invention for pattern formation having a width of partition walls of preferably at most 100 µm, more preferably at most 20 µm in average. Further, it is possible to use the composition for pattern formation having a width of a dot of preferably at most 300 µm, more preferably at most 100 µm in average. Further, it is possible to use it for pattern formation having a height of partition walls of preferably from 0.05 to 50 µm, more preferably from 0.2 to 10 µm, particularly preferably from 0.5 to 3 µm in average.

The liquid repellency of partition walls to be formed from the photosensitive composition can be estimated by the contact angle to water and xylene, and the contact angle to water is preferably at least 90°, more preferably at least 95°. Further, the contact angle to xylene is preferably at least 35°, more preferably at least 40°.

### EXAMPLES

Now, the present invention will be described in further detail with reference to Preparation Examples and Examples, but it should be understood that the present invention is by no means thereby restricted.

Further, in the following, "part(s)" and "%" are based on mass, unless otherwise specified.

The weight average molecular weight is a value measured by a gel permeation chromatography method using polystyrene as the standard substance.

The content of fluorine atoms contained in the fluoropolymer (A) was measured by the following method. That is, an obtained fluororesin was completely burned and decomposed at 1,200°C, and the generated gas was absorbed in 50 g of water. The amount of fluoride ions in the obtained aqueous solution was quantified, and the content of fluorine atoms contained in the fluoropolymer (A) was calculated.

The acid value (mgKOH/g) and the number of ethylenic double bonds per molecule, are theoretical values calculated from the blend proportions of monomers as the raw materials.

Abbreviations of compounds used in the following respective Examples will be shown.
C6FMA: CH₂=C(CH₃)COOCH₂CH₂(CF₂)₆F,
DMS: dimethylsilicone chain-containing methacrylate (manufactured by Shin-Etsu Chemical Co., Ltd., tradename: X-22-174DX),
MAA: methacrylic acid,
2HEMA: 2-hydroxyethyl methacrylate,
AA: acrylic acid,
MMA: methyl methacrylate,
IBMA: isobornyl methacrylate,
2ME: 2-mercaptoethanol,
V70: 2,2'-azobis(4-methoxy-2,4-dimethylvaleronitrile) (manufactured by Wako Pure Chemical Industries, Ltd., tradename: V-70),
MOI: 2-methacryloyloxyethyl isocyanate,
BEI: 1,1-bis((meth)acryloyloxymethyl)ethyl isocyanate
DBTDL: dibutyltin dilaurate,
BHT: 2,6-di-t-butyl-p-cresol,
IR907: radical initiator (manufactured by Ciba Specialty Chemicals K.K., tradename: IRGACURE-907),
IR369: radical initiator (manufactured by Ciba Specialty Chemicals K.K., tradename: IRGACURE-369),
OXE01: 1,2-octadione, 1-[4-(phenylthio)-, 2-(O-benzoyloxime)] (manufactured by Ciba Specialty Chemicals K.K., tradename: OXE01),
OXE02: ethanone 1-[9-ethyl-6-(2-methylbenzoyl)-9H-carbazoyl-3-yl]-1-(O-acetyl oxime) (manufactured by Ciba Specialty Chemicals K.K., tradename: OXE02),
DEAB: 4,4'-bis(diethylamino)benzophenone,
DETX-S: isopropylthioxantone (manufactured by NIPPON KAYAKU CO., LTD., tradename: DETX-S),
D310: dipentaerythritol pentaacrylate (manufactured by NIPPON KAYAKU CO., LTD., tradename: KAYARAD D-310),
CCR1115: cresol novolac type epoxy acrylate (manufactured by NIPPON KAYAKU CO., LTD., tradename: CCR-1115, solid content: 60 mass%),
ZFR1492H: bisphenol F type epoxy acrylate (manufactured by NIPPON KAYAKU CO., LTD., tradename: ZFR-1492H, solid content: 65 mass%),
D310: dipentaerythritol pentaacrylate (manufactured by NIPPON KAYAKU CO., LTD., tradename: KAYARAD D-310),
157S65: bisphenol A novolac type (manufactured by Japan Epoxy Resins Co., Ltd., tradename: EPIKOTE 157S65),
KBM403: 3-glycidoxypropyl trimethoxysilane (manufactured by Shin-Etsu Chemical Co., Ltd. tradename: KBM-403),
DEGDM: diethylene glycol dimethyl ether,
CB: carbon black (average secondary particle size: 120 nm, propylene glycol monomethyl ether acetate solution, CB content: 20 mass%, solid content: 25 mass%),
Organic pigment: mixed organic pigment dispersion (average particle size: 80 nm, propylene glycol monomethyl ether acetate solution, organic pigment content: 20 mass%, solid content: 25 mass%).

### {PREPARATION OF POLYMERS (A1) TO (A5) AND (R1)}

### PREPARATION EXAMPLE 1

### (POLYMERIZATION REACTION)

Into an autoclave having an internal capacity of 1 L and equipped with a stirrer, acetone (556.0 g), C6FMA (96.0 g), MAA (4.8 g), 2-HEMA (96.0 g), MMA (43.2 g), a chain transfer agent 2-ME (6.2 g) and a polymerization initiator V-70 (4.5 g) were charged and polymerized at 40°C for 18 hours with stirring in a nitrogen atmosphere to obtain a solution of copolymer 1. The weight average molecular weight of copolymer 1 was 5,600.

To the obtained acetone solution of copolymer 1, water was added for reprecipitation for purification, and then reprecipitation for purification was carried out by means of petroleum ether, followed by vacuum drying to obtain 237 g of copolymer 1.

### (INTRODUCTION OF ETHYLENIC DOUBLE BONDS)

Into a glass flask having an internal capacity of 500 mL and equipped with a thermometer, a stirrer and a heating device, copolymer 1 (100 g), MOI (47.7 g), DBTDL (0.19 g), BHT (2.4 g) and acetone (100 g) were charged and polymerized at 30°C for 18 hours with stirring to obtain a solution of fluoropolymer (A1). To the obtained acetone solution of fluoropolymer (A1), water was added for reprecipitation for purification, and then reprecipitation for purification was carried out by means of petroleum ether, followed by vacuum drying to obtain 135 g of polymer (A1). The weight average molecular weight was 8,800.

### PREPARATION EXAMPLES 2 to 6

Copolymers 2 to 6 were obtained by a polymerization reaction in the same manner as in the preparation of copolymer 1 except that the mixing (unit: g) of materials was changed as identified in Table 1. Then, polymers (A2) to (A5) each having a side chain containing an ethylenic double bond and polymer (R1) having no side chain containing an ethylenic double bond were obtained by the same reactions as in the preparation of polymer (A1) except that mixing (unit: g) of materials was changed as identified in Table 2.

The weight average molecular weight of the obtained polymer, the content of fluorine atoms in the polymer, the number of ethylenic double bonds (C=C) in one molecule and the acid value (mgKOH/g) are shown in Table 2.

**TABLE 1**

| Polymerization reaction | Preparation Examples | | | | | |
|---|---|---|---|---|---|---|
| | 1 | 2 | 3 | 4 | 5 | 6 |
| C6FMA | 96 | 120 | 96 | 96 | 96 | 96 |
| DMS | - | - | - | - | 4.8 | - |
| MAA | 4.8 | 9.6 | 24 | 28.8 | 24 | 9.6 |
| 2-HEMA | 96 | 96 | 96 | 96 | 96 | - |
| MMA | 43.2 | - | - | - | - | 86.4 |
| IBMA | - | 38.4 | 24 | 19.2 | 19.2 | 48 |
| V70 | 4.5 | 3.5 | 4.2 | 3.6 | 4.2 | 4.4 |
| 2ME | 6.2 | 6.5 | 6.2 | 7.8 | 6.2 | 6.2 |
| Acetone | 556 | 557 | 556 | 556 | 556 | 556 |
| Copolymer | 1 | 2 | 3 | 4 | 5 | 6 |
| Yield | 237 | 238 | 236 | 237 | 237 | 238 |
| Molecular weight | 5600 | 5700 | 5900 | 5600 | 5700 | 5700 |

**TABLE 2**

| Introduction of double bond | Preparation Examples | | | | | |
|---|---|---|---|---|---|---|
| | 1 | 2 | 3 | 4 | 5 | 6 |
| Copolymer used | 1 | 2 | 3 | 4 | 5 | 6 |
| Amount of polymer | 100 | 100 | 100 | 100 | 100 | 100 |
| MOI | 47.7 | 35.8 | 47.7 | - | 47.7 | - |
| BEI | - | - | - | 76.3 | - | - |
| DBTDL | 0.19 | 0.14 | 0.19 | 0.31 | 0.19 | 0.19 |
| BHT | 2.4 | 1.8 | 2.4 | 3.8 | 2.4 | 2.4 |
| Acetone | 100 | 100 | 100 | 100 | 100 | 100 |
| Polymer | A1 | A2 | A3 | A4 | A5 | R1 |
| Yield (g) | 135 | 122 | 134 | 182 | 129 | 98 |
| Molecular weight | 8800 | 7800 | 8900 | 10500 | 8600 | 5800 |
| F atom content (%) | 15 | 20.1 | 15.5 | 11 | 14.9 | 22.4 |
| Number of C=C in one molecule | 9 | 6.9 | 9.2 | 16 | 9.2 | 0 |
| Acid value (mgKOH/g) | 9 | 19 | 44 | 30 | 44 | 26 |

### {PREPARATION OF ALKALI SOLUBLE PHOTOSENSITIVE RESIN (B1)}

### PREPARATION EXAMPLE 7

Into an autoclave having an internal capacity of 1 L and equipped with a stirrer, acetone (555.0 g), AA (96.0 g), 2-HEMA (96.0 g), IBMA (48.0 g), a chain transfer agent DSH (9.7 g) and a polymerization initiator V-70 (7.1 g) were charged and polymerized at 40°C for 18 hours with stirring in a nitrogen atmosphere to obtain a solution of polymer 7. The weight average molecular weight of polymer 7 was 9800.

To the obtained acetone solution of polymer 7, water was added for reprecipitation for purification, and then reprecipitation for purification was carried out by means of petroleum ether, followed by vacuum drying to obtain 240 g of polymer 7.

Then, into a glass flask having an internal capacity of 300 mL equipped with a thermometer, a stirrer and a heating device, polymer 7 (100 g), MOI (48.3 g), DBTDL (0.19 g), BHT (2.4 g) and acetone (100 g) were charged and polymerized at 30°C for 18 hours with stirring to obtain a solution of alkali soluble photosensitive resin (B1).

To the acetone solution of alkali soluble photosensitive resin (B1), water was added for reprecipitation for purification, and reprecipitation for purification was carried out by means of petroleum ether, followed by vacuum drying to obtain 148 g of alkali soluble photosensitive resin (B1). The weight average molecular weight of alkali soluble photosensitive resin (B1) was 13200.

### {PREPARATION OF PHOTOSENSITIVE COMPOSITION}

Photosensitive compositions 1 to 7 were prepared by blending fluoropolymers (A1) to (A5) each having a side chain containing an ethylenic double bond, fluoropolymer (R1) having no side chain containing an ethylenic double bond, alkali soluble photosensitive resin (B1), a photopolymerization initiator (C) and other components in proportions (parts by mass) as identified in Table 3.

**TABLE 3**

| Photosensitive composition | | 1 | 2 | 3 | 4 | 5 | 6 | 7 |
|---|---|---|---|---|---|---|---|---|
| Polymer (A) or (R) | | (A1) 0.56 | (A2) 0.65 | (A3) 0.62 | (A4) 0.99 | (A5) 0.29 | (R1) 0.66 | - |
| Photosensitive resin (B) | B1 | 35.6 | 27.8 | - | - | - | - | - |
| | CCR1115 | - | - | - | - | 57.5 | - | - |
| | ZFR1492H | - | - | 55.9 | 53.1 | - | 55.9 | 55.9 |
| Photopolymerization initiator (C) | IR907 | - | - | - | - | 2.8 | - | - |
| | IR369 | 3.3 | 2.5 | - | - | - | - | - |
| | OXE01 | - | - | 2.6 | - | - | 2.6 | 2.6 |
| | OXE02 | - | - | - | 1.5 | - | - | - |
| | DEAB | - | - | - | 0.5 | 1.5 | - | - |
| | DETX-S | 1.6 | 1.3 | 2.1 | - | - | 2.1 | 2.1 |
| Radical crosslinking agent (D) | D310 | 19.2 | 15.0 | 15.6 | 14.8 | 22.9 | 15.6 | 15.6 |
| Thermosetting agent (E) | 157S65 | 5.5 | 4.3 | - | - | 11.5 | - | - |
| Silane coupling agent (F) | KBM403 | 2.7 | 2.1 | 2.6 | 2.5 | 1.7 | 2.6 | 2.6 |
| Colorant (G) | CB | - | - | 63.0 | 83.9 | - | 63.0 | 63.0 |
| | Organic pigment | 65.3 | 85.5 | - | - | - | - | - |
| Diluting agent | DEGDM | 155.0 | 111.0 | 108.0 | 93.0 | 152.0 | 108.0 | 108.0 |
| Proportion (%) of polymer (A) or (R) in total solid content | | 1 | 0.85 | 0.41 | 0.65 | 0.38 | 0.89 | 0 |

### {FORMATION OF PARTITION WALLS AND PIXELS}

Partition walls and pixels were formed on a substrate using the above-prepared photosensitive compositions by methods shown in the following Examples 1 to 8.

### EXAMPLE 1

Photosensitive composition 1 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 100 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 2,000 mJ/cm² by means of an ultrahigh pressure mercury lamp from the side (front side) on which the partition walls were formed, was carried out, and heat treatment at 200°C for 1 hour was further carried out to obtain a substrate on which partition walls having an average thickness of 2.0 µm were formed.

A thermosetting ink containing a green pigment and having a solid content of 25% was injected by means of an ink jet apparatus within regions of 100 µm x 200 µm partitioned by the partition walls, and dried at 100°C for 5 minutes on a hot plate. The volume of the ink layer after heat curing was 40 pL. Then, heat treatment was carried out at 200°C for 30 minutes to form pixels.

### EXAMPLE 2

Photosensitive composition 2 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 200 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 3,000 mJ/cm² by an ultrahigh pressure mercury lamp from the side (rear side) on which the partition walls were formed was carried out, and heat treatment at 200°C for 1 hour was further carried out to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 3

Photosensitive composition 3 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 200 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 3,000 mJ/cm² by an ultrahigh pressure mercury lamp from the side (front side) on which the partition walls were formed was carried out, and heat treatment at 200°C for 1 hour was further carried out to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 4

Photosensitive composition 4 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 100 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 200 mJ/cm² by an ultrahigh pressure mercury lamp from the side (front side) on which the partition walls were formed was carried out, and heat treatment at 200°C for 1 hour was further carried out to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 5

Photosensitive composition 5 was applied on a glass substrate on which a chromium black matrix was formed by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 100 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 4,000 mJ/cm² by an ultrahigh pressure mercury lamp from the side (front side) on which the partition walls were formed was carried out, to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 6

Photosensitive composition 1 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 100 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, heat treatment at 200°C for 1 hour was carried out to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 7

Photosensitive composition 6 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 200 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 3,000 mJ/cm² by an ultrahigh pressure mercury lamp from the side (front side) on which the partition walls were formed was carried out, and heat treatment at 200°C for 1 hour was further carried out to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 8

Photosensitive composition 7 was applied on a glass substrate by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 200 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, irradiation with 3,000 mJ/cm² by an ultrahigh pressure mercury lamp from the side (front side) on which the partition walls were formed was carried out, and heat treatment at 200°C for 1 hour was further carried out to obtain a substrate on which partition walls having an average thickness of 2.0 µm were formed.

In the same manner as in Example 1, an ink was injected within regions partitioned by the partition walls to form an ink layer thereby to form pixels.

### EXAMPLE 9

Photosensitive composition 5 was applied on a glass substrate on which a chromium black matrix was formed by means of a spinner and then dried at 100°C for 2 minutes on a hot plate. A mask having a lattice pattern formed (line=20 µm, lattice space = 100 µm × 200 µm) was placed above a coating film with a gap of 30 µm, followed by irradiation with 4,000 mJ/cm² by means of an ultrahigh pressure mercury lamp. Then, the substrate was subjected to development treatment at 25°C for 40 seconds by means of a 0.1 mass% tetramethylammonium hydroxide aqueous solution containing a surfactant, and then washed with water and dried to form partition walls.

Then, heat treatment at 200°C for 1 hour was carried out to obtain a substrate on which partition walls having an average thickness of 2.0 µm were formed.

Since the exposure dose was high, the line width of the partition walls was thick, whereby no regions partitioned by the partition walls could be obtained by the development. Accordingly, ink injection was not carried out.

### {EVALUATION}

With respect to the substrates on which partition walls and pixels were formed, the developability, the shape of the partition walls, the line width of the partition walls, the water-and-oil repellency and the ink jet coating property were measured and evaluated by the following methods. The results are summarized in Table 4.

### (DEVELOPABILITY)

One completely developed was identified by O, and one having a portion not developed was identified by ×.

### (SHAPE OF PARTITION WALLS)

The substrate was cut, and the shape of the cross section of the partition walls was observed by a scanning electron microscope (manufactured by Hitachi Ltd.).

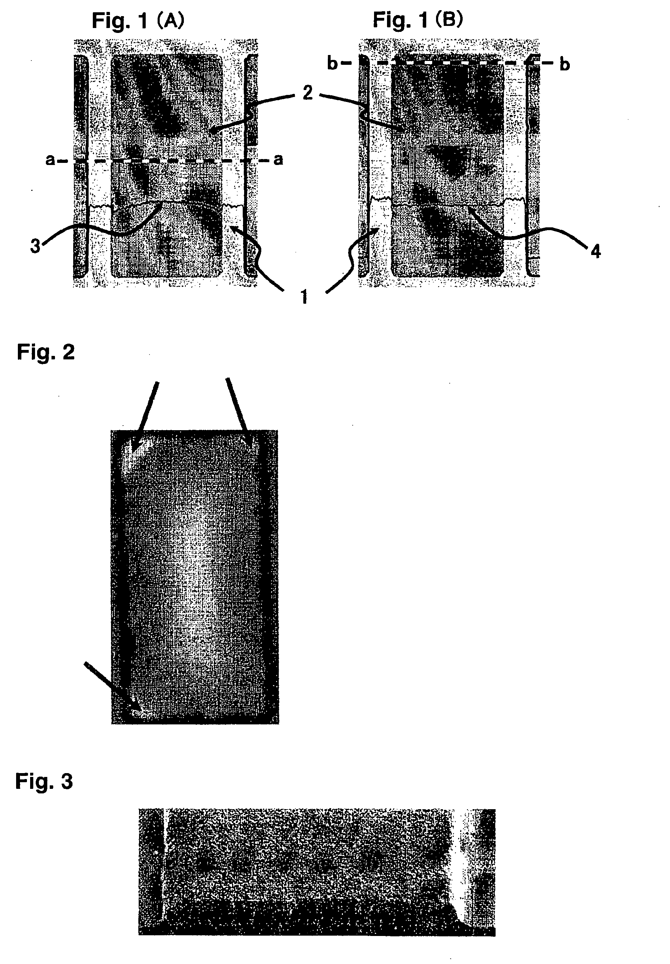

Fig. 3 is an observed image of the cross-sectional shape of partition walls obtained in Example 4.

### (LINE WIDTH OF PARTITION WALLS)

The line widths of the upper base and the lower base (line width of a partition wall in contact with the transparent substrate) of the partition walls were measured by an ultra deep shape measuring microscope (manufactured by KEYENCE CORPORATION).

### (LIQUID REPELLENCY)

A film comprising a coating film cured product of photosensitive composition was formed on a glass substrate under the same conditions as for formation of the partition walls in Examples 1 to 9 except that no mask was used, and the liquid repellency on the surface of the film was evaluated. Specifically, it was evaluated by the contact angle (degree) of the film surface to water and xylene. The contact angle is an angle between the solid surface and the tangent line against the liquid surface at a point where the solid and the liquid are in contact with each other, and it was defined by the angle on the side containing the liquid. The larger the angle, the better the liquid repellency of the film. The contact angle to water being at last 95° was represented by ○, the same contact angle being at least 90° and less than 95° was represented by △, and the same contact angle being less than 90° was represented by ×. The contact angle to xylene being at least 40° was represented by O, the same contact angle being at least 35° and less than 40° was represented by △, and the same contact angle being less than 35° was represented by ×.

### (UNIFORMITY IN THE THICKNESS OF THE INK LAYER)

The uniformity in the thickness of the ink layer was measured by an ultra deep shape measuring microscope (manufactured by KEYENCE CORPORATION). The value of (h1-h2)/h1 was represented, where h1 is the maximum thickness, and h2 is the minimum thickness. Fig. 1 illustrates a surface observed image of partition walls and pixels obtained in Example 1. In Fig. 1, (A) illustrates a film thickness profile of a cross-section along a line a-a of an ink layer, and the maximum thickness of the ink layer was observed at the center of the pixel. In Fig. 1, (B) illustrates a film thickness profile of a cross-section along a line b-b of the same ink layer as in (A), and the minimum thickness of the ink layer was observed at the upper portion of an image of the pixel. The maximum thickness was 2.02 µm and the minimum thickness was 1.65 µm, and accordingly (h1-h2)/h1=0.18.

Fig. 2 illustrates a surface observed image of partition wall and pixel obtained in Example 6. In this case, there are regions not coated with an ink at edge portions at a pixel portion indicated by arrows, and accordingly the minimum thickness was 0 µm, and (h1-h2)/h1=1.

**TABLE 4**

| | | | Examples | | | | | Comparative Examples | | | |
|---|---|---|---|---|---|---|---|---|---|---|---|
| Ex. | | | 1 | 2 | 3 | 4 | 5 | 6 | 7 | 8 | 9 |
| Composition | | | 1 | 2 | 3 | 4 | 5 | 1 | 6 | 7 | 5 |
| Step | Exposure | Exposure dose | 100 | 200 | 200 | 100 | 100 | 100 | 200 | 200 | 4000 |
| | Post-exposure | Direction Exposure dose | Front 2000 | Rear 3000 | Front 3000 | Front 200 | Front 4000 | Nil | Front 3000 | Front 3000 | Nil |
| | Postbaking | Temperature Time (hour) | 200 1 | 200 1 | 200 1 | 200 1 | Nil | 200 1 | 200 1 | 200 1 | 200 1 |
| Physical properties | Developability | | ○ | ○ | ○ | ○ | ○ | ○ | ○ | ○ | × |
| | Shape of partition walls | | Rectangular | Reverse tapered | Forward tapered | Forward tapered | Forward tapered | Forward tapered | Forward tapered | Forward tapered | - |
| | Line width of partition walls | Upper base | 20.9 | 21.2 | 18.8 | 18.5 | 20.5 | 18.1 | 18.9 | 18.8 | - |
| | | Lower base | 21.5 | - | 22.6 | 23.3 | 26.8 | 21.6 | 21.5 | 21.5 | - |
| | Liquid repellency | Water | ○ | ○ | ○ | ○ | ○ | ○ | ○ | × | ○ |
| | | Xylene | ○ | ○ | ○ | ○ | ○ | ○ | △ | × | ○ |
| | Uniformity in thickness of an ink layer | | 0.18 | 0.16 | 0.09 | 0.15 | 0.06 | 1 | 1 | - | - |

In Example 6, since the post-exposure is not carried out, the uniformity in the thickness of an ink layer is poor. In Example 7, since a fluoropolymer having no side chain containing an ethylenic double bond is contained, the liquid repellency is slightly poor, and the uniformity in the thickness of an ink layer is poor. In Example 8, since the polymer (A) of the present invention is not contained, the liquid repellency and the uniformity in the thickness of an ink layer are poor.

### INDUSTRIAL APPLICABILITY

The process of the present invention is suitably used for production of partition walls and pixels for an electronic device such as partition walls and pixels for a color filter, partition walls and pixels for an ITO electrode of a liquid crystal display device, partition walls and pixels for an organic EL display device, and partition walls and pixels for a circuit wiring board.

The entire disclosure of Japanese Patent Application No. 2007-143638 filed on May 30, 2007 including specification, claims, drawings and summary is incorporated herein by reference in its entirety.

## Claims

1. A process for producing a substrate having partition walls and pixels formed thereon, which comprises forming partition walls on a substrate by a step (11) of coating the substrate with the following photosensitive composition, a step (12) of drying a coating film of the photosensitive composition, an exposure step (13), a development step (14) and a post-exposure step (15); and forming a film by a step (21) of injecting an ink within dots which are regions partitioned by the above partition walls and a step (22) of drying a coating film of the ink, the film satisfying (h1-h2)/h1<0.3 where h1 is the maximum thickness of an ink layer in one dot and h2 is the minimum thickness, thereby to obtain pixels:
photosensitive composition: a photosensitive composition comprising a polymer (A) having a side chain containing a group represented by the following formula 1 or a group represented by the following formula 2 and a side chain containing an ethylenic double bond in one molecule:
-CFXR^{f} (1)
wherein X is a hydrogen atom, a fluorine atom or a trifluoromethyl group, and R^{f} is an alkyl group having at most 20 carbon atoms which may have an etheric oxygen atom, at least one of hydrogen atoms of which is substituted by a fluorine atom, or a fluorine atom;
-(SiR¹R²O)ₙ-SiR¹R²R³ (2)
wherein each of R¹ and R² which are independent of each other, is a hydrogen atom, an alkyl group, a cycloalkyl group or an aryl group, R³ is a hydrogen atom or a C₁₋₁₀ organic group, and n is an integer of from 1 to 200.

2. The process according to Claim 1, wherein the step (21) of injecting an ink is carried out by an ink jet method, a spray coating method or a screen printing method.

3. The process according to Claim 1 or 2, which comprises a postbaking step (16) of subjecting the partition walls to heat treatment, after the post-exposure step (15) and before the step (21) of injecting an ink within dots.

4. The process according to any one of Claims 1 to 3, which comprises a step (23) of subjecting the ink layer to heat treatment after the step (22) of drying an ink.

5. The process according to any one of Claims 1 to 4, wherein in the post-exposure step (15), exposure is carried out by means of an ultrahigh pressure mercury lamp or a high pressure mercury lamp.

6. The process according to any one of Claims 1 to 4, wherein in the post-exposure step (15), exposure is carried out by means of a low pressure mercury lamp with an exposure dose of at most 500 mJ/cm².

7. A process for producing a color filter, which comprises forming partition walls and pixels on a substrate by the process as defined in any one of Claims 1 to 6.

8. A process for producing an organic EL device, which comprises forming partition walls and pixels on a substrate by the process as defined in any one of Claims 1 to 6.
